# EUROPEAN PATENT APPLICATION

(11) **EP 0 848 421 A2**
(43) Date of publication of application: **17.06.1998**
(21) Application number: 97310099.3
(22) Date of filing: 15.12.1997
(51) Int. Cl.: H01L 21/768

(54) **Selective physical vapor deposition conductor fill in IC structures**

(30) Priority: 16.12.1996 US 768058
(71) Applicant: APPLIED MATERIALS, INC., Santa Clara, California 95054-3299 (US)
(72) Inventor: Ramaswami, Seshadri, San Jose, California 95118 (US); Nulman, Jaim, Palo Alto, California 95306 (US)
(74) Representative: Bayliss, Geoffrey Cyril

(57) **Abstract**

The present invention provides a method and apparatus for selective PVD conductor fill in IC structure incorporating an optical end point detecting mechanism. The present invention utilizes a high density plasma source and the technique of bias sputtering of film layers formed on a substrate to eliminate crowning or cusping problems associated with deposition on the field of a patterned substrate to provide selective deposition of a conductive material in a trench, hole or via formed on the substrate. The use of a high density plasma source and separate bias power sources applied to the target and the substrate support member (and capacitively coupled to the substrate) enable the target to be sputtered and the substrate to be etched, either simultaneously or in alternating steps.

## Description

The present invention relates generally to methods and apparatus for fabricating electronic devices on substrates, including integrated circuits. More particularly, the present invention relates to methods for selectively or preferentially depositing conductive material in trenches, holes or vias formed in a substrate surface using physical vapor deposition (PVD) with a high density plasma (HDP).

Sputtering or physical vapor deposition is a known technique for depositing thin films'onto a substrate. Typically in a sputtering system, a glow discharge plasma is generated in an atmosphere of inert gas by maintaining an inert gas atmosphere at a pressure from about 1 milliTorr to about 10 milliTorr and by applying an RF or DC potential across a two electrode system comprising a cathode and an anode. A plasma is created in the space between the electrodes in which the inert gas atmosphere becomes at least partially ionized. The plasma is bounded from each of the electrodes by a plasma sheath or dark space. A high negative potential applied to the cathode (with respect to the plasma) then accelerates ions from the plasma onto the cathode (usually the target or desired coating material) where cascade lattice collisions cause the ejection of neutral target atoms. At gas pressures below about 10 milliTorr, the ejected or sputtered atoms travel across the plasma, essentially without interaction, and deposit on the anode which may comprise the substrate or wafer to be coated. At higher gas pressures from about 10 milliTorr to about 50 milliTorr, the sputtered neutral atoms can interact with the plasma while traversing therethrough. This results in a nearly isotropic directional distribution of the sputtered material at the surface of the wafer or substrate.

The surface of the wafer being coated is typically patterned and frequently includes high aspect ratio apertures and vias. Apertures or vias are formed in a substrate to provide a conductive path (trench) or contact (hole) between film layers. PVD is a preferred technique for coating substrates with metals. However, as geometries shrink it becomes more difficult to fill high aspect ratio features without forming voids in the feature. As deposition material is deposited in the aperture and on the field of the substrate, the aperture is closed in a phenomenon known as "crowning" where the deposited material closes the top of the aperture before it has been completely filled. Material is deposited on the areas between the holes and trenches, commonly referred to as the "field" ofthe wafer, and closes the openings of the small features. Generally, it is desired to have little or no metallic or conductive coatings on field areas of the wafer, at least in the same plane as the top of the trenches or holes forming conductive paths or contacts. The build up of material on the field adjacent a hole or trench leads to the problem of "shadowing" in which an overhanging edge of such material can shield or deflect sputtered material from reaching the sidewalls and floor of the hole or trench. Thus, it is difficult to selectively or preferentially fill the trenches, vias, or holes without plating the field areas, too.

In filling holes or trenches by sputtering metals in an inert gas atmosphere at high pressures, greater than about 10 milliTorr, the neutral atoms are sputtered from the target in a density distribution that is generally related to the cosine of the angle between a line normal to the target surface and the trajectory of the sputtered atom. Scattering of these atoms in a high density plasma, however, results in a distribution more nearly isotropic at the surface of the wafer. A trajectory to the substrate that will provide at least a component of neutral sputtered atoms at oblique angles to the substrate surface will provide some coverage of the walls of trenches, holes or vias in the wafer. High density plasma provides such trajectories. Orbital, rotational or back and forth reciprocal motion ofthe wafer during deposition and controlled heating ofthe wafer surface may also be used to provide conformal (uniform) film coverage over the wafer surface. However these latter techniques are not particularly useful in selectively or preferentially coating holes, trenches, or vias.

The present invention provides a method and apparatus for selectively depositing conductive coatings in holes, trenches or vias to the exclusion or diminution of deposition on field areas on a substrate. The present invention utilizes a high density plasma source and the technique of bias sputtering of film layers formed on a substrate to eliminate crowning or cusping problems associated with deposition on the field of a patterned substrate to provide selective deposition of a conductive material in a trench, hole or via formed on the substrate. The use of a high density plasma source and separate bias power sources applied to the target and the substrate support member (and capacitively coupled to the substrate) enable the target to be sputtered and the substrate to be etched, either simultaneously or in alternating steps. One advantage of this method and apparatus is that the deposition of the film on the field of the substrate can be controlled to prevent the openings of small features patterned on substrates from closing before the feature has been adequately filled with deposition material.

In one embodiment of the present invention, a uniform barrier layer is formed over the entire surface of the substrate using, for example, conventional sputtering techniques. The barrier layer is generally a metallic nitride or oxide and is a conductor or semiconductor compared to the preferred deposition material used in vias, interconnects or lines. A conducting film is then deposited over the barrier layer using HDP-PVD techniques. Bias sputtering of the substrate field (i.e. the application of a negative electrical bias to attract inert gas ions from the plasma) is performed either simultaneously, or in alternating steps, with HDP-PVD to etch away the deposition material depositing on the field of the substrate. Sputter etching of the field allows the bottom and sidewalls of the holes, trenches or vias to be coated without the problems of shadowing caused by crowning or cusping of the film deposited on the field adjacent the feature opening. Deposition of material continues until the feature is completely filled. The alternating steps of deposition and sputter etching can be repeated as many times as desired to fill or partially fill the holes, trenches or vias, while leaving little or no conductor deposition on the field areas.

The techniques of the present invention are preferably performed with a high density plasma (10 to 50 milliTorr) inert gas atmosphere to fill and etch to the desired specification in a single step. In this instance, RF and DC bias levels, barrier layer material and gas pressure are adjusted to give the desired result.

So that the manner in which the above recited features, advantages of the present invention are attained and can be understood in detail, a more particular description of the invention, summarized above, may be had by reference to the embodiments thereofwhich are illustrated in the drawings.

It is to be noted, however, that the drawings illustrate only typical embodiments of this invention and are therefore not to be considered limiting of its scope, for the invention may involve other equally effective embodiments.
Figure 1 is a schematic diagram in section showing a glow discharge plasma between two electrodes in an inert gas atmosphere at low pressure; and
Figures 2(a)-(f) are cross-sectional schematic diagrams showing how a hole or trench in a substrate is filled with a conductor and field areas of the substrate are etched free of conductor by the sequential application of bias sputtering and ion etching; and
Figure 3 is a flow diagram of a computer program for controlling the process and apparatus of the present invention.

High density plasma (HDP) physical vapor deposition (PVD) is a useful tool in coating substrates or wafers of semiconductors used in fabricating microelectronic circuits. In HDP-PVD, an inert gas atmosphere is maintained at a pressure of about 10 to about 50 milliTorr in a vacuum chamber having a cathode (usually a target) and an anode (usually the wafer or substrate to be coated).

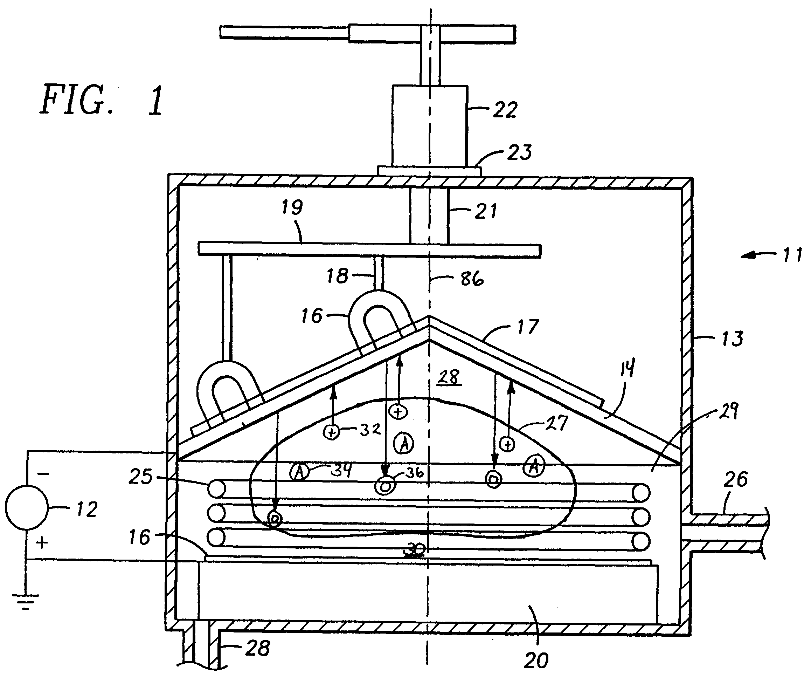

Figure 1 is a schematic drawing showing a magnetron sputtering system according to the present invention. A vacuum chamber 11 of conventional type is supplied with a gas inlet port 26 and an exhaust outlet port 28. A substrate support pedestal 20 is disposed at the lower end of the chamber 11 and a target 14 is received at the upper end of the chamber 11. Target 14 is electrically insulated from the wall 13 of chamber 11. Chamber wall 13 is kept at ground potential while target may also contain an RF generator, if desired, in the 5-30 MHz frequency range which could be capacitively coupled to target 14.

A substrate 16 is placed on support pedestal 20 which may be cooled by refrigerated coils or the like (not shown). The substrate 16 is connected to the ground side of power supply 12. The high negative voltage power supply is shown as aDC power supply, but it will be understood that it could be a pulsed DC supply, an AC supply or an RF power supply if desired. An inert gas, such as argon (Ar), is charged into chamber 11 via gas inlet 26, preferably at a selected flow rate regulated by a mass flow controller (not shown) of conventional design. In the present invention, an inert gas pressure between about 10 mT and about 60 mT is preferred. The high negative potential (-V) supplied by power supply 12 causes a plasma (glow discharge) to form in the Argon gas 34 disposed between the substrate 16 and the target 14 at region 27. Positive ions 32 of gas from the plasma region 27 bombard the target 14 causing sputtering of neutral atoms 36 from its surface, initially leaving the surface oftarget 14 in the aforementioned cosine distribution, and generally toward the substrate.

While a target of any shape may be used in accordance with the present invention, the preferred target for use in the present invention is a conical target 14, most preferably the type known as an inverted Delta source. Magnets 16 (shown schematically as simple horseshoe magnets) are mounted on a similarly cone shaped rotatable platform 17 which is attached via arms 18 to a rotating plate 19. Rotating plate 19 is attached to a shaft 21 which sealingly penetrates chamber wall 13 and is rotated at several hundred RPM by a drive motor 22 through gear box 23, or the like. The magnets 16 are positioned to cause a particular erosion profile or pattern in the target 14 which is optimally uniform across its surface.

When operating the chamber 11 at relatively high gas pressures between about 10 mT and about 60 mT, the usual assumption that sputtered target atoms 36 follow a straight line trajectory is no longer valid. For example, at pressures below about 1 mT a typical target 14 to substrate 16 spacing of 115 mm is less than the mean free path of a sputtered atom in the gas. However, at about 20 mT gas pressure the mean free path of a sputtered target atom is about 4 mm. Thus, the typical target distance from the substrate is several tens of mean free path lengths long depending on gas pressure. Of course, at higher gas pressures the mean free path before collision in the gas is even lower. Typically, the sputtered atoms 36 undergo a few hundred collisions before arriving at the surface of the wafer 16. This multitude of collisions causes the sputtered atoms to lose kinetic energy to the gas and, meanwhile, lose their original directionality (i.e., loss of the cosine distribution). The target atom collisions lead to an essentially isotropic flux of particles in the plasma. These conditions allow the use of a gas diffusion model to predict the distribution of sputtered target atoms in the gas as the atoms approach the substrate.

The glow discharge plasma formed in region 27 between the cathode 14 and the anode 20 is separated from the cathode (target) 14 by a cathode dark space or plasma sheath 28 and from the anode 20 by an anode dark space or plasma sheath 30. The plasma region 27 contains partially ionized positive argon ions (+) 32, neutral argon atoms (A) 34 and sputtered cathode (target) ions (O) 36. The ionized positive argon ions 32 are attracted to the cathode and accelerated across the cathode dark space 28 by the high negative potential provided by the power supply 12. When the fast moving ions 32 hit the cathode (target) 14, lattice cascade reactions occur which eject neutral cathode (target) atoms 36 in a generally cosine distribution toward the anode 20 supporting the substrate 16 to be coated.

At gas pressures less than about 10 milliTorr, the mean free path of target atoms is usually greater than the distance from the target 14 to the substrate 16 and the sputtered or ejected atoms 36 impinge upon the surface of the substrate 16 substantially in accordance with a cosine distribution. At higher gas pressures, between about 10 and about 50 milliTorr, the sputtered target atoms 36 undergo multiple collisions with the argon atoms 34 in the plasma 27 and the dark spaces 28,30 and lose their directionality. Therefore, the sputtered atoms 36 become "thermalized" or randomized in their motion and impinge on the substrate surface from all directions or essentially isotopically.

The use of a high density plasma (HDP) at pressures between about 10 and about 50 milliTorr is contemplated in the techniques of the present invention. For a given set of sputtering conditions, such as the target/substrate geometry, type of inert gas, target material, barrier layer material and high voltage source, an optimum pressure regime can be determined to perform the conductor hole or trench filling techniques to be described. The preferred substrate material in the semiconductor industry is silicon, usually in crystalline form.

When depositing metals, particularly aluminum (Al) or copper (Cu), onto a crystalline silicon substrate, it is generally necessary to first deposit a barrier layer over the substrate in order to prevent unwanted metallic "doping" or diffusion of the metal ions or atoms into the substrate lattice. Physical vapor deposition techniques have been used for this purpose and typically metal nitrides or oxides have been used for this barrier layer. A commonly used barrier layer for aluminum is titanium nitride (TiN), tantalum nitride (TaN) or any one of several other barrier layers could be used if desired.

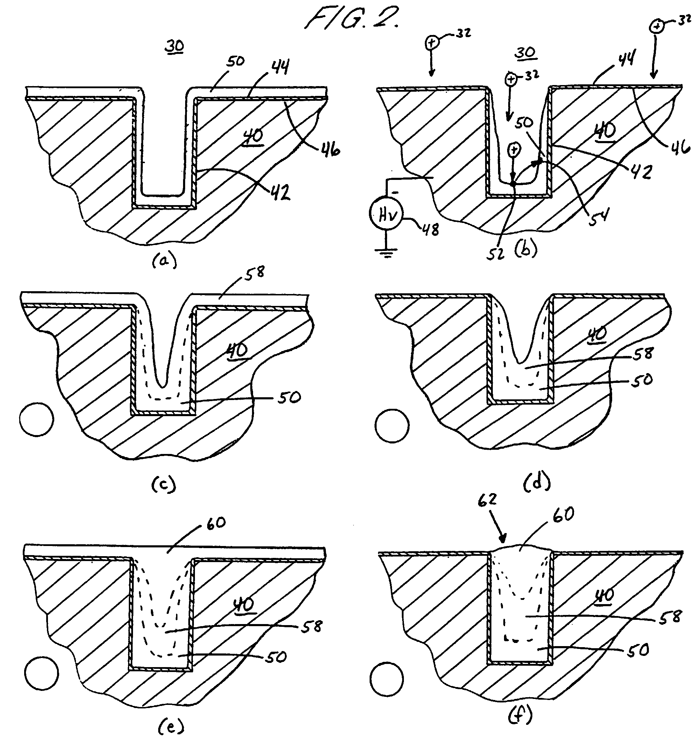

Figure 2(a) is a schematic sectional view of a substrate 40 having a hole or trench 42 previously etched in its surface and in which it is desired to selectively or preferentially fill with a conductor (usually metal) to form a contact point or a low resistance electrical current path in an integrated circuit being fabricated on the substrate 40. According to the techniques of the present invention, a conductive barrier layer 44 is preferably first deposited over the substrate 40, including the surface of the hole 42. The uniformity of PVD film layers is improved by substrate temperature control, physical motion of the substrate during the deposition process, use of higher gas pressures, etc. Any and all such techniques may be employed in accordance with the present invention to achieve uniform conformal coating in the steps requiring such for the process of filling holes or trenches with a conductive metal.

Once the barrier layer 44 of desired thickness has been deposited in the hole or trench 42 and on the field area 46 of the substrate 40, the technique of bias sputtering is begun to deposit a metal layer 50 over the field and hole surfaces of the barrier layer 44.

Figure 2(b) shows that a secondary power supply 48 is then attached to substrate 40 to apply a negative bias to the entire barrier layer 44 and any metal of layer 50 deposited thereon. The secondary power supply 48 may provide DC, pulsed DC, AC or RF power as desired. A negative bias is applied via the conductive barrier layer 44 to the metal deposition layer 50 which, because of its excellent conductivity, becomes an equipotential surface at a negative voltage with respect to the plasma.

The negative bias applied to layer 50 attracts argon ions 32 from the plasma which are accelerated across the anode dark space 30 and impinge on the metal layer 50 essentially in a vertical direction. This process causes etching and re-sputtering of the previously deposited metal layer 50 by action of the impacting argon ions 32. Neutral metal atoms are etched away from metal layer 50 lying over the field area 46. These atoms are rapidly ionized in the high density plasma. However, in the hole or trench 42, the vertically impinging argon ions 32 cause "forward sputtering" of atoms from the metal layer 50 (such as from point 52), which are primarily preferentially deposited on the walls of the trench or hole 42 (such as at point 54). Accordingly, by etching away all of the metal layer 50 from the field areas 46, the problem of shadowing the hole, which often results in the formation of voids, is eliminated. This causes the hole or trench 42 to tend to become filled with the re-sputtered or forward sputtered metal.

Optimally, the ion etching (re-sputtering) process on the substrate field areas 46 stops once the barrier layer 44 is reached. For example, if the barrier layer 44 is less conductive than the metal layer 50 deposited thereon, and an RF secondary power supply 48 is used to apply the negative bias by capacitive coupling across the barrier layer 44, then once the metal layer 50 over the field areas 46 is etched away by action of the argon ions 32, there is essentially no more bias on the field, except on whatever portion of the metal layer 50 remains (i.e., in the hole or trench 42, or in uneven patches in field areas 26). Thus, marked or distinct etching endpoints on the barrier layer 44 may be obtained, while filing holes or trenches 42 simultaneously. Of course, the difference in resistance between the barrier layer 44 and the metal layer 50 will cause a reduction in the electric field potential (and hence current) at the surface ofthe barrier layer 44 once the metal layer 50 is removed. Thus, by sensing current flow in the secondary power supply, the endpoint of etching can be controlled accurately at the point where the current reaches a steady state lower value after beginning the ion etching portion of the cycle.

Figures 2(c) and 2(d), as well as Figures 2(e) and 2(f), show how the hole or trench 42 can be filled with a metal plug 62 by sequentially cycling between a sputter deposition step (Figures 2(a), (c) and (e))and an ion etching step (Figures 2(b), (d) and (f)). The sequential layers 50, 58, 60 combine to selectively or preferentially form a metal plug 62 having no voids therein. It will be recognized that the process of hole filling may include any number of cycles between the sputtering and etching, with each step having the same of different durations or conditions.

Furthermore, when using HDP PVD, the bias level placed on the substrate by the secondary power source 48, vis-a-vis the RF and DC bias levels applied to the target 14, can be tailored to achieve sputtering of metal onto the field 46 and trench 42 while simultaneously removing the metal layer formed on the field 46 by bombardment with argon ions 32. Using an inductive coil or antenna to maintain the plasma, the DC and RF bias levels on the target 14 can be tailored so that sputtering of the target occurs at a faster rate than etching of the field areas 46 on the substrate.

The process can be implemented using a computer program product 141 that runs on a conventional computer system comprising a central processor unit (CPU) interconnected to a memory system with peripheral control components, such as for example a 68400 microprocessor, commercially available from Synenergy Microsystems, California The computer program code can be written in any conventional computer readable programming language such as for example 68000 assembly language, C, C⁺⁺_{,} or Pascal. Suitable program code is entered into a single file, or multiple files, using a conventional text editor, and stored or embodied in a computer usable medium, such as a memory system of the computer. If the entered code text is in a high level language, the code is compiled, and the resultant compiler code is then linked with an object code of precompiled windows library routines. To execute the linked compiled object code, the system user invokes the object code, causing the computer system to load the code in memory, from which the CPU reads and executes the code to perform the tasks identified in the program.

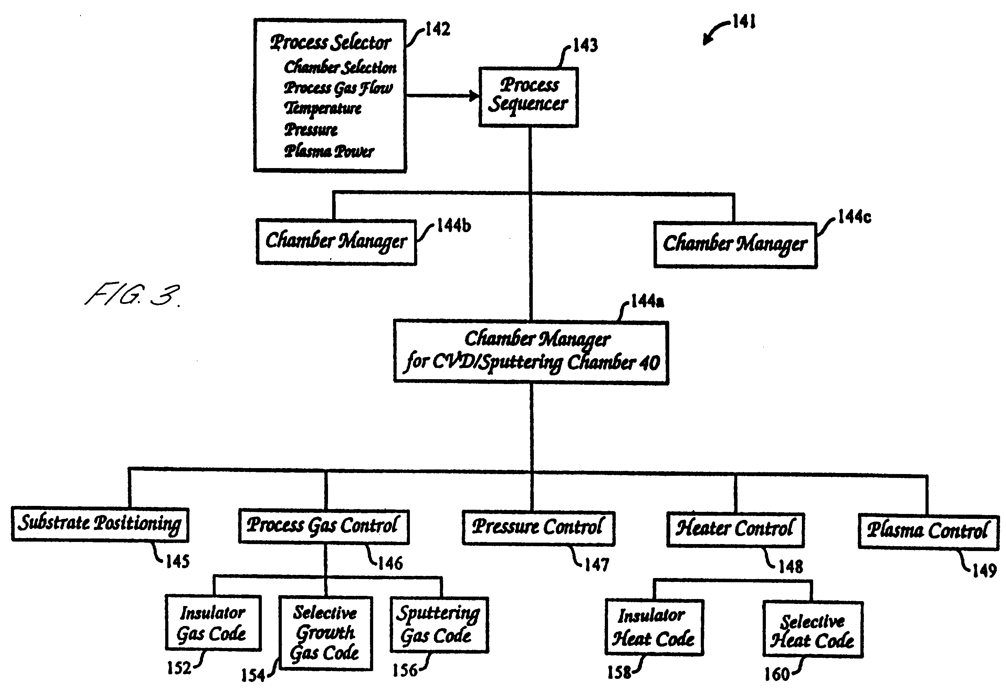

Figure 3 shows an illustrative block diagram of the hierarchical control structure of the computer program 141. A user enters a process set and process chamber number into a process selector subroutine 142. The process sets are predetermined sets of process parameters necessary to carry out specified processes in a specific process chamber, and are identified by predefined set numbers. The process set the desired process chamber, and (ii) the desired set of process parameter needed to operate the process chamber for performing a particular process. The process parameters relate to process conditions such as, for example, process gas composition and flow rates, temperature, pressure, plasma conditions such as RF bias power levels and magnetic field power levels, cooling gas pressure, and chamber wall temperature.

A process sequencer subroutine 143 comprises program code for accepting the identified process chamber and set of process parameters from the process selector subroutine 142, and for controlling operation of the various process chambers. Multiple users can enter process set numbers and process chamber numbers, or a user can enter multiple process set numbers and process chamber numbers, so the sequencer subroutine 143 operates to schedule the selected processes in the desired sequence. Preferably the sequencer subroutine 143 includes a program code to perform the steps of (I) monitoring the operation of the process chambers to determine if the chambers are being used, (ii) determining what processes are being carried out in the chambers being used, and (iii) executing the desired process based on availability of a process chamber and type of process to be carried out. Conventional methods of monitoring the process chambers can be used, such as polling. When scheduling which process is to be executed, the sequencer subroutine 143 can be designed to take into consideration the present condition of the process chamber being used in comparison with the desired process conditions for a selected process, or the "age" of each particular user entered request, or any other relevant factor a system programmer desires to include for determining scheduling priorities.

Once the sequencer subroutine 143 determines which process chamber and process set combination is going to be executed next, the sequencer subroutine 143 causes execution of the process set by passing the particular process set parameters to chamber manager subroutines 144a-c which control multiple processing tasks in different process chambers according to the process set determined by the sequencer subroutine 143. For example, the chamber manager subroutine 144a comprises program code for controlling PVD process operations, within the described process chamber 40. The chamber manager subroutine 144 also controls execution of various chamber component subroutines or program code modules, which control operation bf the chamber components necessary to carry out the selected process set. Examples of chamber component subroutines are substrate positioning subroutine 145, process gas control subroutine 146, pressure control subroutine 147, heater control subroutine 148, and plasma control subroutine 149. These different subroutines function as deposition program code means for (a) generating a glow discharge in an inert gas atmosphere in the space between a target and a patterned substrate to be processed; (b) depositing a conductive material layer on the substrate; (c) applying a negative bias, with respect to the glow discharge plasma, to the substrate to be treated to attract ions from the plasma to the substrate while continuing to deposit the conductive material, whereby the attracted ions from the plasma selectively etch away the conductive layer from the field areas of the substrate while causing forward sputtering in the holes or trenches to fill the holes or trenches with the conductive material. Those having ordinary skill in the art would readily recognize that other chamber control subroutines can be included depending on what processes are desired to be performed in the process chamber 11.

In operation, the chamber manager subroutine 144a selectively schedules or calls the process component subroutines in accordance within the particular process set being executed. The chamber manager subroutine 144a schedules the process component subroutines similarly to how the sequencer subroutine 143 schedules which process chamber 11 and process set is to be executed next. Typically, the chamber manager subroutine 144a includes steps of monitoring the various chamber components, determining which components needs to be operated based on the process parameters for the process set to be executed, and causing execution of a chamber component subroutine responsive to the monitoring and determining steps.

Operation of particular chamber component subroutines will now be described. The substrate positioning code or subroutine 145 comprises program code for controlling chamber components that are used to load the substrate 16 onto the chamber support 20, and optionally to lift the substrate to a desired height in the chamber 11 to control the spacing between the substrate and the target 14. When a substrate 16 is loaded into the process chamber 11, the substrate support 20 is lowered to receive the substrate, and thereafter, the support is raised to the desired height in the chamber. The substrate positioning subroutine 145 controls movement of the support 20 in response to the process set parameters related to the support height that are transferred from the chamber manager subroutine 144a.

The process gas control subroutine 146 has program code for controlling process gas composition and flow rates. Generally, the process gases supply lines for each of the process gases, include (I) safety shut-off valves (not shown) that can be used to automatically or manually shut off the flow of process gas into the chamber, and (ii) mass flow controllers (also not shown) that measure the flow of a particular gas through the gas supply lines. When toxic gases are used in the process, the several safety shut-off valves are positioned on each gas supply line in conventional configurations. The process gas control subroutine 146 controls the open/close portion of the safety shut-off valves, and also ramps up/down the mass flow controllers to obtain the desired gas flow rate. The process gas control subroutine 146 is invoked by the chamber manager subroutine 144a, as are all chamber component subroutines, and receives from the chamber manager subroutine process parameters related to the desired gas flow rates. Typically, the process gas control subroutine 146 operates by opening the gas supply lines, and repeatedly (I) reading the necessary mass flow controllers, (ii) comparing the readings to the desired flow rates received from the chamber manager subroutine 144a, and (iii) adjusting the flow rates of the gas supply lines as necessary. Furthermore, the process gas control subroutine 146 includes steps for monitoring the gas flow rates for unsafe rates, and activating the safety shut-off valves when an unsafe condition is detected.

The process gas control subroutine 146 comprises hole filling program code for operating the chamber in a selective or preferential hole filling mode. In the preferential hole filling mode, the sputtering gas program code 156 can also be provided to introduce sputtering gas into the PVD chamber 11 during performance of the PVD process step. As discussed above, the desired process gas flow rates are transferred to the process gas control subroutine 146 as process parameters.

When the pressure control subroutine 147 is invoked, the desired or target pressure level is received as a parameter from the chamber manager subroutine 144a. The pressure control subroutine 147 operates to measure the pressure in the chamber 11 by reading one or more conventional pressure nanometers connected to the chamber, compare the measure value(s) to the target pressure, obtain PID (proportional, integral, and differential) values from a stored pressure table corresponding to the target pressure, and adjust the throttle valve according to the PID values obtained from the pressure table. Alternatively, the pressure control subroutine 147 can be written to open or close the throttle valve to a particular opening size to regulate the chamber 40 at the desired pressure.

The heater control subroutine 148 comprises program code for controlling the temperature of the support 20 used to heat the substrate 16. The heater control subroutine 148 includes hole filling program code 158 for operating in a hole filling stage in which the substrate is maintained at a desired temperatures T within the range of temperatures △ T. Typically, the subroutine 148 is programmed to ramp up the temperature of the support from ambient chamber temperatures to a set point temperature. In this step, the heater control subroutine 148 is invoked by the chamber manager subroutine 144a and receives a ramp rate temperature parameter.

The heater control subroutine 148 measures temperature by measuring voltage output of a thermocouple located in the support, compares the measured temperature to the setpoint temperature, and increases or decreases current applied to the heater 20 to obtain the desired ramp rate or setpoint temperature. The temperature is obtained from the measured voltage by looking up the corresponding temperature in a stored conversion table, or by calculating the temperature using a fourth order polynomial. When radiant lamps are used as the heater, the heater control subroutine 148 gradually controls a ramp up/down of current applied to the lamp that increases the life and reliability of the lamp. Additionally, a built-in fail-safe mode can be included to detect process safety compliance, and to shut down operation of the heater 80 if the process chamber 40 is not properly set up.

The plasma control subroutine 149 comprises program code for forming a capacitively coupled and/or inductively coupled deposition plasma in the chamber during operation of the chamber in a chemical vapor deposition mode. The subroutine 149 sets the RF bias voltage power level applied between the target 14 and the support 20 in the chamber 11, and optionally sets the level of the magnetic field generated in the chamber, to form the deposition plasma. Similar to the previously described chamber component subroutines, the plasma control subroutine 149 is invoked by the chamber manager subroutine 144a In operation, the plasma condition 149 includes steps for reading both "forward" power applied to the plasma generator 116, and "reflected" power flowing through the chamber 40. An excessively high reflected power reading indicates that the plasma has not been ignite, and the plasma control subroutine 149 restarts or shuts down the process. The read power levels are compared against target levels, and the current is adjusted to control the plasma for applying a sinusoidal wave current to the generator to form a rotating magnetic field in the chamber 40. The sinusoidal wave needed to generate a desired magnetic field can be obtained from a stored table of sinusoidal values corresponding to magnetic field strengths, or calculated using a sinusoidal equation.

A second plasma control subroutine 149 may be employed to control a secondary power source 48 coupled to the substrate 40 to form a bias thereon. This power source can be used to generate a plasma sufficient to etch the field of the substrate. Alternatively, the power source may be used simultaneously with the power source 12. This second plasma control subroutine 149 may monitor the electric field potential or resistance at the surface of the barrier layer 44 and determine the end point of the etching process.

The foregoing descriptions may make other, alternative arrangements apparent to those of skill in the art. The aim of the appended claims is to cover all such changes and modifications as fall within the true spirit and scope of the invention.

## Claims

1. A method for filling trenches or holes in a substrate also having a field area with a conductive material comprising the steps of:
(a) generating a glow discharge in an inert gas atmosphere in the space between a target and a patterned substrate to be processed;
(b) depositing a conductive material layer on the substrate;
(c) applying a negative bias, with respect to the glow discharge plasma, to the substrate to be treated to attract ions from the plasma to the substrate while continuing to deposit the conductive material, whereby the attracted ions from the plasma selectively etch away the conductive layer from the field areas of the substrate while causing forward sputtering in the holes or trenches to fill the holes or trenches with the conductive material.

2. The method of claim 1 wherein a barrier layer is deposited on the substrate prior to depositing the conductive material.

3. The method of claim 1 or claim 2 wherein the metal layer is deposited onto a dielectric layer.

4. The method of claim 3 wherein the selective etching of the conductive field areas ends on the dielectric layer.

5. The method of claim 4 wherein the conductive layer comprises a metal.

6. The method of claim 5 wherein the bias is applied by an RF power supply operating at a frequency of from about 50 kilo hertz to 10 of mega hertz.

7. The method of claim 4, claim 5 or claim 6 wherein the bias is applied to the conductive layer by a pulsed DC power supply.

8. The method of any one of claims 4 to 7 wherein the bias is applied to the conductive layer by use of a dual frequency RF power supply.

9. The method of claim 8 wherein the steps of uniformly and conformally depositing a conductive material layer and selectively etching away the conductive layer from the field areas of the substrate are performed repetitively.

10. The method of any one of the preceding claims wherein the steps are performed in an inert gas at a pressure of from about 1 to about 10 milliTorr.

11. The method of claim 10 wherein the steps of depositing a conductive material layer and selectively etching away the conductive layer from the field areas of the substrate are performed repetitively.

12. The method of any one of the preceding claims wherein the steps are performed in high density inert gas atmosphere at a pressure of from about 1 to about 50 milliTorr.

13. The method of claim 12 wherein the steps of depositing a conductive material layer and selectively etching away the conductive layer in the field areas are performed simultaneously by adjusting the bias, high voltage and gas pressures.

14. The method of claim 12 or claim 13 wherein the steps of depositing a conductive material layer and selectively etching away the conductive layer in the field areas are performed by sequentially adjusting the bias, high voltage and gas pressure.

15. A method as claimed in any one of the preceding claims wherein the method is used to fabricate electronic devices on substrates including integrated circuits and in particular wherein said method preferentially deposits conductive material in trenches, holes vias formed in a substrate surface using physical vapour deposition with a high density plasma.

16. Apparatus for performing a method for filling trenches or holes in a substrate also having a field area with a conductive materials comprising:
(a) means for generating a glow discharge in an inert gas atmosphere in the space between a target and a patterned substrate to be processed;
(b) means for depositing a conductive material layer on the substrate;
(c) means for applying a negative bias, with respect to the glow discharge plasma, to the substrate to be treated so that when the apparatus is used ions from the plasma are attracted to the substrate while continuing to deposit the conductive material, whereby the attracted ions from the plasma selectively etch away the conductive layer from the field areas of the substrate while causing forward sputtering in the holes or trenches to fill the holes or trenches with the conductive material.
